# EUROPEAN PATENT APPLICATION

(11) **EP 1 921 834 A1**
(43) Date of publication of application: **14.05.2008**
(21) Application number: 07380316.5
(22) Date of filing: 13.11.2007
(51) Int. Cl.: H04M 1/677, H04M 1/725

(54) **Educational mobile telephone**

(30) Priority: 13.11.2006 ES 200602433 P
(71) Applicant: Imaginarium S.A., 50197 Zaragoza (ES)
(72) Inventor: Tena Comadrán, D. Felix, 50197 Zaragoza (ES)
(74) Representative: Ungria Lopez, Javier

(57) **Abstract**

Educational mobile telephone, of utility for use preferably by children, having a SIM control card with a memory/agenda along with a screen and a series of function buttons, and in which the incoming and outgoing calls are restricted to telephones whose numbers are stored in its memory/agenda (3), while messages are restricted to reception from any mobile telephone (20) by means of a code, the telephone numbers (4) being stored in the memory/agenda (3) by means external to the actual mobile telephone (2) which interact with it, and which mobile telephone (2), which incorporates a series of buttons, has two buttons (10) and (11) corresponding to individual numbers pre-assigned for direct call.

## Description

As stated in the title of this specification, the following invention relates to an educational mobile telephone, being based on a novel concept for use by children, being preferably used in "hands-free" mode in such a way that it is conceived for being used by children, lacking a physical alphanumeric keypad and having as its essential objective to educate a child in the responsible use and consumption of a mobile telephone. So, the mobile telephone displays large buttons and certain representative icons.

To achieve this, stored in the memory/agenda of the card for the mobile telephone are telephone numbers, supervised by the father/mother, in such a way that the incoming and outgoing calls are restricted to the numbers stored in the memory/agenda (SIM card), in other words, calls to numbers that are not stored in its memory/agenda of the SIM card will not be able to be made.

In addition, the child cannot send SMS messages though he/she can receive messages, and the reception of messages is restricted to the telephone numbers stored in the memory/agenda of the SIM card of the telephone.

In this way, and since the telephone lacks a numeric keypad, it is not possible, using the telephone itself, to store telephone numbers in its memory/agenda, and so the storage of the telephone numbers in the memory/agenda of the telephone will be done via a particular web site, preferably that of the company marketing the mobile telephone, by means of an SMS message from another mobile telephone and via a password or from a conventional mobile telephone in which its SIM card is fitted.

Likewise, when the telephone numbers stored in the memory/agenda are displayed on the screen of the mobile telephone together with the name of the person to which they correspond, they are associated with an image which the child recognises and, without having to know how to read, he/she recognises to whom that number belongs.

The educational mobile telephone incorporates a key or button for emergency calls, along with two keys or buttons for direct access to the agenda and for fast dialling by means of confirmation by the call connection button.

Equally, the numbers stored in the memory/agenda of the SIM card for the educational mobile telephone are associated with some icons.

### FIELD OF APPLICATION OF THE INVENTION

This specification describes an educational mobile telephone, which is of special utility for educating children in the responsible use and consumption of mobile telephony.

### PRIOR ART OF THE INVENTION

As is known, there is a wide range of models of mobile telephone on the market, all of them with alphanumeric keypads via which the different functions of those phones are performed.

So, one of the functions of mobile telephones is to permit, by means of its alphanumeric keypad, storage of desired telephone numbers, along with their name, in the memory/agenda of the SIM card for the phone, in such a way that when it appears on screen just the number and name are shown.

Likewise, in the case of conventional mobile telephones, incoming and outgoing calls are not restricted, in other words, calls can be made to any number that is wished and, equally, calls can be received from any telephone.

### DESCRIPTION OF THE INVENTION

The present specification describes an educational mobile telephone, being of utility for educating children in the responsible use and consumption of mobile telephony, having a SIM control card with a memory/agenda along with a screen and a series of function buttons, and in which the incoming and outgoing calls are restricted to telephones whose numbers are stored in the memory/agenda of its SIM card, with the telephone numbers having been stored in the memory/agenda thereof by means external to the actual telephone with which they interact, and which mobile telephone, lacking in a physical alphanumeric keypad, incorporates a series of buttons, with two of them corresponding to individual numbers pre-assigned for direct call.

In this way, the two pre-assigned numbers for direct call with the simple pressing of the corresponding key provide access to the numbers of the agenda materialising the call by pressing the call connection key, in such a way that the said numbers can correspond to the telephone numbers for the preferred or most usual call which the child can make, such as to the father or mother, or to someone else.

Moreover, in a first practical execution, the means for storage of the telephone numbers in the memory/agenda of the SIM card for the educational mobile telephone are based on a predetermined web site, from which, by means of a code, of four digits for example, a message is sent to the telephone and the desired number is stored in its memory/agenda. So, the web site can be that of the company marketing the educational mobile telephone.

Likewise, in a second practical embodiment, the means for storage of the telephone numbers in the memory/agenda of the SIM card for the educational mobile telephone are based in an SMS message from another mobile telephone, with prior introduction of a code of, for example, four digits.

The educational mobile telephone is able to receive SMS messages from phones in relation to the telephone numbers stored in its memory/agenda, but it is not possible to send messages by means of it.

With the aim of facilitating the use of the mobile telephone for a child, it incorporates two direct access buttons to two numbers in the agenda of the SIM card, and for call connection by means of pressing the call connection button, allowing a telephone to be had whose use is easy for children.

Likewise, the educational mobile telephone incorporates a direct call button for emergencies, by means of which the child can, when necessary, make such a call with great simplicity and speed.

Moreover, the telephone numbers stored in the memory/agenda of the educational mobile telephone appear on the screen associated with a design for being recognised by the child, so that, even though the child cannot read the name, he/she will associate that number with the person to whom it corresponds.

The educational mobile telephone is preferably for use in the "hands-free" mode, so that it can be used without direct physical contact with the phone, though it incorporates a selection button "hands-free" - "earphone / personal conversation".

The educational mobile telephone is associated with a stand with a circular base and of low height, provided in its upper part with a recess for positioning the telephone, in such a way that the child can leave the telephone on it and talk, when it is in the "hands-free" mode, while he/she is playing or performing some other activity.

So, in short, the aim is for children to be able to have an educational mobile telephone adapted to their needs, being easy to use and which permits them to make a responsible use and consumption thereof.

In order to complement the description that is going to be made forthwith, and with the aim of facilitating a better understanding of the characteristics of this invention, this specification is accompanied by a set of plans containing figures in which, on an illustrative rather than limiting basis, the most characteristic details of the invention have been represented.

### BRIEF DESCRIPTION OF THE DRAWINGS

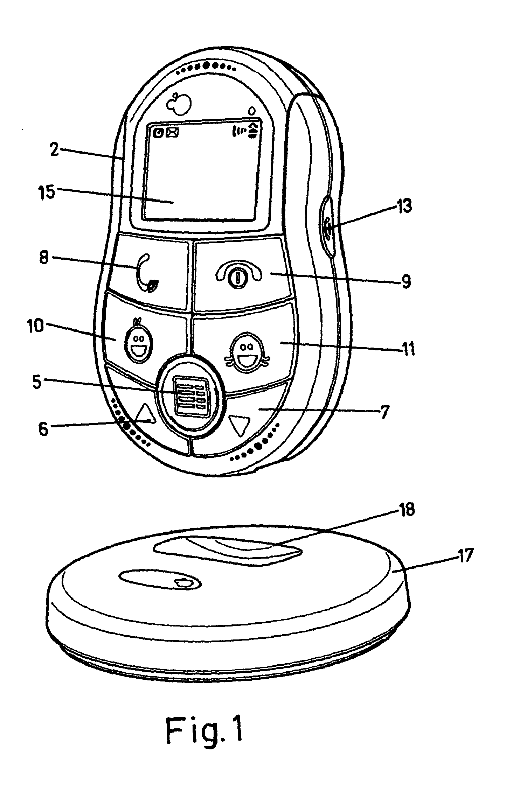

Figure 1.- Shows a perspective view of an educational mobile telephone and its support stand, facilitating its use "hands-free".

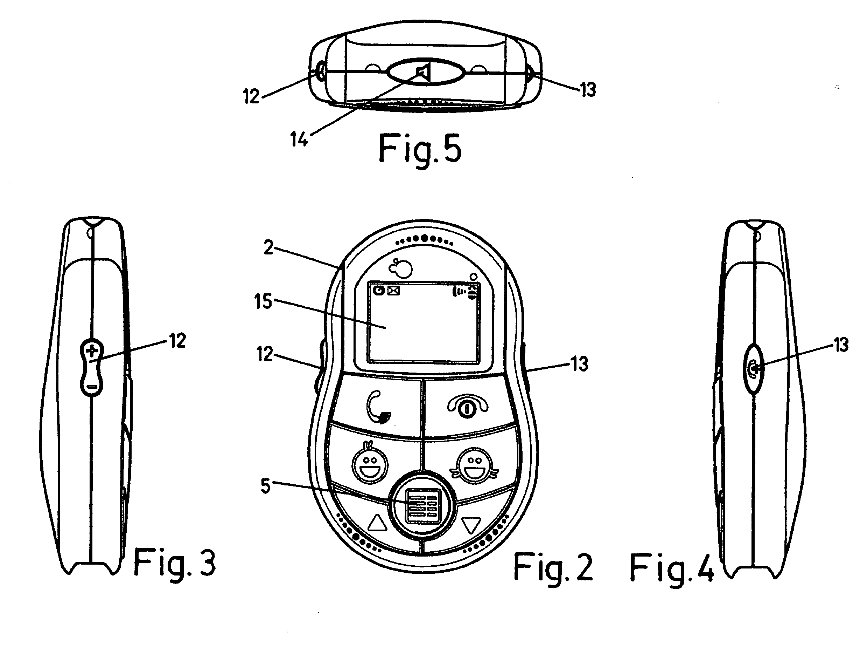

Figure 2.- Shows a front view of an educational mobile telephone in which can be seen its screen and a series of buttons.
Figure 3.- Shows a view in side elevation of the educational mobile telephone of the previous figure, where the volume adjustment button can be seen.
Figure 4.- Shows a second view in side elevation of the educational mobile telephone of figure 3, where the emergency call button can be seen.
Figure 5.- Shows a plan view of the educational mobile telephone of figure 3, where the button for changing from "hands-free" - "earphone / personal conversation" can be seen.

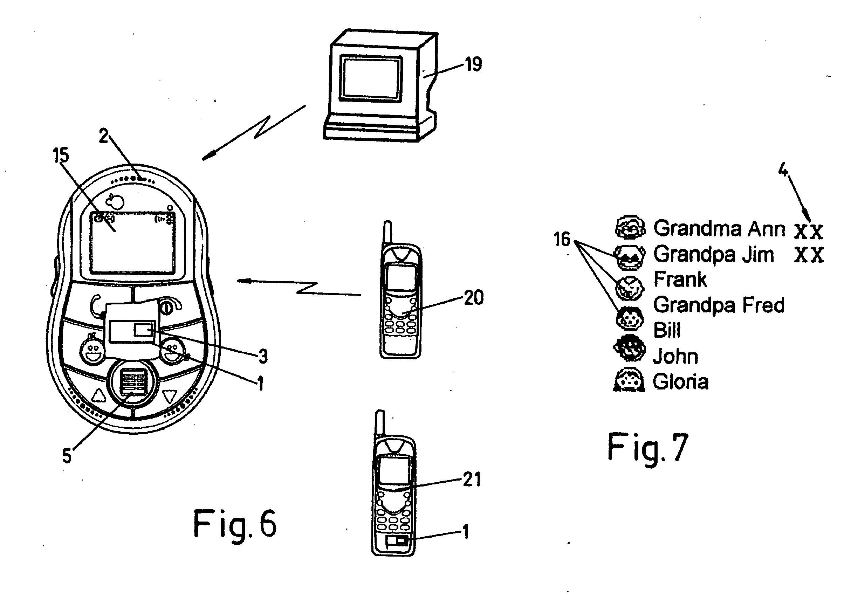

Figure 6.- Shows a diagrammatic view of an educational mobile associated with the means of storage of telephone numbers in its memory/agenda, with its SIM card having been represented with the memory/agenda for storage of the desired numbers.
Figure 7.- Shows a view in of a list of telephone numbers with the name of the person and associated with an identification design by the child.

### DESCRIPTION OF THE PREFERRED EMBODIMENT

With the figures in view and in accordance with the adopted numbering, we can see how the educational mobile telephone 2 incorporates a SIM card 1 with a memory/agenda 3 where a set of telephone numbers 4 is stored, more than 200 in total, in which the incoming and outgoing calls are restricted.

The telephone numbers 4 are stored in the memory/agenda 3 of the SIM card 1 of the mobile telephone 2 by means external to the actual educational mobile telephone 2 which interact with it, whose educational mobile telephone 2, lacking the physical alphanumeric keypad, incorporates a series of buttons, two of which correspond to individual pre-assigned numbers for direct call.

Moreover, the external means for storage of the telephone numbers 4 in the memory/agenda 3 of the SIM card 1 of the educational mobile telephone 2 which interact with it can be based on a predetermined web site which is accessed by means of the corresponding computing equipment 19 and by means of which, via a code, of four digits for example, a message is sent with the desired number being stored in the memory/agenda 3 of the educational mobile telephone 2. Said web site can be that of the company marketing the educational mobile telephone 2.

Likewise, the means for storage of the telephone numbers 4 in the memory/agenda 3 of the SIM card 1 of the mobile telephone 2 can be based on an SMS message sent from a telephone 20 which interacts with the mobile telephone 2 by means of a code, of four digits for example.

Equally, the means for storage of the telephone numbers 4 in the memory/agenda 3 of the SIM card 1 of the mobile telephone 2 can be based on another mobile telephone 21 provided with an alphanumeric keypad in which the SIM card 1 of the educational mobile telephone 2 has been fitted.

So, the SIM card 1 of the educational mobile telephone 2 will be removed and fitted in a mobile telephone 21 with an alphanumeric keypad storing the desired number in it. It will then be fitted back into the educational mobile telephone 2.

The educational mobile telephone 2 is able to receive SMS messages from other telephones, by means of a code, of four digits for example, but it itself is not able to send messages.

By means of the button 5 of the educational mobile telephone 2, access is had to the menu and by means of the buttons 6 and 7, the cursor can be displaced on the screen searching for the different options that appear, permitting right/left and up/down displacement.

Moreover, in addition to the button 8 for call connection and the button 9 for call disconnection, as well as for on/off, the educational mobile telephone 2 also incorporates a pair of buttons 10 and 11 relating to individual pre-assigned telephone numbers for direct call. These pre-assigned numbers will correspond to those numbers which the child uses most often, such as the father and mother.

The assignment of numbers relating to the pre-assignment buttons will be done by means of searching for them in the menu and, once selected, the desired pre-assignment key is pressed for the certain length of time, for example 4 seconds.

Equally, as well as the button 12 for volume adjustment, the educational mobile telephone 2 also incorporates a button 13 for direct emergency call.

Moreover, even though the educational mobile telephone 2 has a preferred functioning mode of "hands-free" it incorporates a button 14 so that it can be adopted to "personal conversation" earphone mode.

The telephone numbers 4 stored in the memory/agenda 3 of the SIM card 1 of the educational mobile telephone 2 appear on the screen associated with a design 16 (icon) for their recognition by the child, being of use when the child cannot read and which allow him/her to associate the design with the person to whom that telephone number belongs.

The educational mobile telephone 2 is associated with a stand 17 with a circular base and of low height, provided in its upper part with a recess 18 for positioning the educational mobile telephone 2, in such a way that the child can place the educational mobile telephone 2 on the stand 17 and talk while playing. The educational mobile telephone 2 can have a speaker in its front face or has a speaker in its front face and another in its rear face.

The mobile telephone 2 will be able to be charged since it has the corresponding connection in its lower part.

So, indeed, the mobile telephone 2 is conceived for being used by children both on account of its ergonomic structure and the size of the buttons, which are larger than conventional ones, and due to the incorporation of icons associated with the owners of the telephone numbers stored in its memory/agenda.

Moreover, given that the telephone numbers stored in the memory/agenda of the mobile telephone 2 will be those which the father/mother consider appropriate since they are most likely to be the ones who will know the access codes, both from the web site developed for the purpose and from any telephone.

## Claims

1. EDUCATIONAL MOBILE TELEPHONE, being of utility for use preferably by children, having a SIM control card with a memory/agenda along with a screen and a series of function buttons, **characterised in that** the incoming and outgoing calls are restricted to telephones whose numbers are stored in its memory/agenda (3), while messages are restricted to reception from any mobile telephone (20) by means of a code, in such a way that the telephone numbers (4) are stored in the memory/agenda (3) by means external to the actual mobile telephone (2) which interact with it, said mobile telephone (2) incorporates a series of buttons, corresponding two buttons (10) and (11), each one to a pre-assigned number for direct call.

2. EDUCATIONAL MOBILE TELEPHONE, according to claim 1, **characterised in that** the external means for storage of the telephone numbers (4) in the memory/agenda (3) are based on a web site developed for that purpose, accessible by means of a corresponding computing equipment (19), by which, and through a code, the desired message is sent.

3. EDUCATIONAL MOBILE TELEPHONE, according to claim 1, **characterised in that** the means for storage of the telephone numbers (4) in the memory/agenda (3) are based on an SMS message sent from any telephone (20) through a code.

4. EDUCATIONAL MOBILE TELEPHONE, according to claim 1, **characterised in that** the mobile telephone (2) is able to receive SMS messages from any telephone (20) through an access code, but it itself cannot send messages.

5. EDUCATIONAL MOBILE TELEPHONE, according to claim 1, **characterised in that** the mobile telephone (2) incorporates two buttons (10) and (11) for direct access to respective numbers in the agenda.

6. EDUCATIONAL MOBILE TELEPHONE, according to claim 1, **characterised in that** the educational mobile telephone (2) incorporates a button (13) for direct emergency access.

7. EDUCATIONAL MOBILE TELEPHONE, according to claim 1, **characterised in that** the telephone numbers (4) stored in the memory/agenda (3) on the screen (15) of the educational mobile telephone (2) appear associated with a design (16) for recognition by the child.

8. EDUCATIONAL MOBILE TELEPHONE, according to claim 1, **characterised in that** the mobile telephone (2) preferably for use in "hands-free" mode incorporates a button (14) for selection of "hands-free" - "earphone/personal conversation" mode.

9. EDUCATIONAL MOBILE TELEPHONE, according to claim 1, **characterised in that** the mobile telephone (2) is associated with a stand (17) with a circular base and of low height, provided in its upper part with a recess (18) for positioning the mobile telephone (2).
